# EUROPEAN PATENT APPLICATION

(11) **EP 4 245 722 A1**
(43) Date of publication of application: **20.09.2023**
(21) Application number: 22161814.3
(22) Date of filing: 14.03.2022
(51) Int. Cl.: C01B 32/956, C30B 29/36

(54) **METHOD AND APPARATUS FOR PRODUCING SIC**

(71) Applicant: Industriekeramik Hochrhein GmbH, 79793 Wutöschingen-Horheim (DE)
(72) Inventor: Reinger, Marco, 79787 Lauchringen (DE)
(74) Representative: Weickmann & Weickmann PartmbB

(57) **Abstract**

The present invention refers to a method for producing SiC, and particularly high-purity SiC, comprising the steps of (a) providing a mixture comprising at least one saccharide, silica and a solvent in a reactor, (b) heating the mixture provided in step (a) to a temperature T1 ranging from 200°C to 600°C, and (c) heating the mixture obtained in step (b) in an inert gas atmosphere to a temperature T2 ranging from 1600-2000°C. Particularly, the present method might provide SiC in the form of a monocrystal. Further, the present invention refers to apparatuses for use in the method of the present invention.

## Description

The present invention refers to a method for producing SiC comprising the steps of (a) providing a mixture comprising at least one saccharide, silica and a solvent in a reactor, (b) heating the mixture provided in step (a) to a temperature T1 ranging from 200°C to 600°C, and (c) heating the mixture obtained in step (b) in an inert gas atmosphere to a temperature T2 ranging from 1600-2000°C.

Further, the present invention refers to apparatuses for use in the method of the present invention. An apparatus according to the present invention for heating a mixture comprising at least one saccharide, silica and a solvent comprises: a sealable reactor comprising a gas inlet system with gas inlet valves and at least one gas outlet including at least one gas outlet valve; and a microwave heater. An apparatus according to the present invention for providing a mixture comprising at least one saccharide, silica and a solvent comprises: a first reaction vessel including a stirring device and a heating jacket; an ion exchanger comprising an ion exchange resin and a heating jacket; a collection vessel and a second reaction vessel including a stirring device, wherein the first reaction vessel is configured to be in fluid contact with a first end of the ion exchanger, the collection vessel is configured to be in fluid contact with a second end of the ion exchanger and the second reaction vessel is configured to be in fluid contact with the collection vessel.

The rapid progress of electromobility and the increasing importance of regenerative energy are just some of countless future fields whose further development will cause a steadily increasing need of semiconductor materials in the coming years. One particularly suitable semiconductor material is silicon carbide (SiC). Low circuit losses, high frequencies, high electrical and thermal conductivity as well as high temperature resistance are just some of the advantages that have caused the demand for SiC semiconductors to rise sharply in recent years. With the resulting steadily growing demand for SiC wafers as a basis for the production of semiconductor components, the raw material SiC -in high quality and purityis more in demand than ever for the growth of SiC monocrystals.

The known methods for SiC synthesis are the Acheson process, chemical vapor deposition (CVD), sol-gel processes and the direct synthesis of SiC from elemental carbon and silicon.

The Acheson process is the only suitable method for the large-scale production of SiC. The starting point is mixtures of quartz sand (SiO₂) and coke (C), which are converted to SiC at temperatures above 2000°C. Due to the raw materials used, the purity of the synthesized SiC is not sufficient for growing SiC semiconductor crystals. Electrically active impurities such as Al, B, N, etc. are particularly critical. Therefore, subsequent purification processes (e.g. acid washing) or the addition of salts such as sodium chloride during the synthesis process are required. Another problem with the Acheson process is the deviation from the optimum stoichiometry, so that usually not only SiC is present in the product, but also free carbon or free silicon. Further disadvantages are the very high process temperatures and the very coarse SiC grain sizes (c.f. US 9,534,316 B2), which require grinding prior to SiC monocrystal growth. Grinding processes, however, lead to further contamination due to the strong abrasive effect of SiC.

CVD processes are characterized by the reaction of gaseous compounds containing Si and C, so-called precursors, at temperatures of 1200-1400°C with the formation of solid SiC. Due to the low reaction temperatures, ß-SiC is formed, which is less suitable for crystal growth of 4H and 6H polytypes. Also problematic are occurring impurities of boron and nitrogen, which negatively influence SiC crystal growth and act as doping elements. In addition to high manufacturing costs and low productivity, additional thermal processes are required to achieve a grain size suitable for crystal growth.

In sol-gel processes a liquid Si-containing organic or inorganic compound, such as ethyl silicate, reacts with a C-containing organic compound, such as a phenol- or xylene-based resin, at temperatures typically between 1700 and 2000°C under vacuum or inert gas. In many cases, the synthesis requires the use of catalysts and additives with undesirable elemental components such as sulphur, nitrogen, or oxygen, which can act as a source of contamination. In order to remove or reduce impurities and by-products, toxic or environmentally hazardous substances are required, e.g. gaseous halogen compounds. As a consequence, sol-gel processes are very complex and cost-intensive. Further, the very fine resulting particle sizes require downstream thermal processes to build up the grain sizes required for crystal growth. In addition to expensive starting materials, the yield is often low, which severely limits the commercial use of sol-gel processes, especially for larger production quantities.

In the direct synthesis of SiC through the reaction of elemental carbon and elemental silicon in powder form, a major problem is obtaining the starting materials in the required high purities. Additionally problematic is the adjustment of the desired SiC polytype and stoichiometry, which is influenced for example by oxygen uptake of Si by oxidation or by uncontrolled evaporation of Si. Often, nitrogen contamination also occurs, which acts as a donor in SiC. Recent developments try to overcome these disadvantages by a multi-stage heat treatment at temperatures up to 2200-2300°C and under high vacuum (up to 10-5 mbar) as well as long holding times of up to 100 hours and the use of gas-permeable barrier layers. The very high temperatures, long holding times and the high vacuum are costextensive and thus limit mass production. Moreover, high costs arise from the required Si and C raw materials of high purity (> 99.999 %) and the control over the synthesis processes and products in such a combined powder synthesis and crystal growth process is very poor.

Thus, there is a need for an improved method for producing SiC, which overcomes the disadvantages of the prior art processes. The method of the present invention allows for the production of high-purity SiC, particularly in the form of monocrystals, in a resource- and cost-efficient way. The non-toxic starting materials are silica as a silicon source and a saccharide as a carbon source, which can even be obtained from renewable raw materials.

The method of the present invention comprises the provision of a mixture of the starting materials, which is preferably in the form of a purified suspension. The mixture is then heated for drying, pyrolysis and carbothermic reduction to form SiC. Heating of the starting material may be performed by microwave radiation and/or inductive heating for a particularly energy-efficient synthesis process. Further, the present method allows for the provision of high-purity SiC, which may be used to grow SiC mono crystals with a diameter of e.g. 75 to 300 mm without additional purification or thermal processing. The SiC (monocrystal) of the present invention has high purity and a reduced number of defects.

In a first aspect, the present invention is directed to a method for producing SiC, comprising
(a) providing a mixture comprising at least one saccharide, silica and a solvent in a reactor,
(b) heating the mixture provided in step (a) to a temperature T1 ranging from 200°C to 600°C, and
(c) heating the mixture obtained in step (b) in an inert gas atmosphere to a temperature T2 ranging from 1600-2000°C to obtain SiC.

In step (a) a mixture comprising at least one saccharide, silica and a solvent is provided in a reactor. In a preferred embodiment, the mixture is free of catalysts and additives. In a particularly preferred embodiment, the mixture consists of at least one saccharide, silica and a solvent, such as of sucrose, fumed silica and water.

The saccharide may be selected from mono- or oligosaccharides and preferably mono-, di- or trisaccharides or mixtures therefrom. An oligosaccharide according to the present invention comprises two to twenty monosaccharides, which may be the same or different. The molecular mass of the saccharide may be 50-600 g/mol, preferably 200-400 g/mol, more preferably 300-400 g/mol and particularly around 342 g/mol.

In a preferred embodiment, the saccharide is selected from glucose, fructose, galactose, maltose, isomaltose, sucrose, lactose, raffinose, maltotriose or mixtures thereof and is preferably sucrose.

The content of saccharide in the mixture of step (a) may be 30-45 wt.-%, preferably 35-42 wt.% based on the total mass of the mixture. The content of silica in the mixture of step (a) may be 9-30 wt.-%, preferably 14-18 wt.% based on the total mass of the mixture.

The molar ratio of carbon to silicon in the mixture of step (a) may be 3:1-7:1, preferably 4:1-6:1, and particularly 5:1. The ratio of carbon to silicon is particularly relevant for the production of SiC, which is intended for monocrystal growth. In case an excess of either carbon or silicon is present, a crystal with a high number of defects is obtained or even no SiC crystal is formed at all.

The mixture provided in step (a) further comprises a solvent. The solvent may be selected from water, alcohol, particularly a monoalcohol such as ethanol or propanol, or a mixture thereof. In a preferred embodiment, the solvent is water and particularly demineralized water. In a particularly preferred embodiment, the solvent is purified water, wherein particularly impurities like Na⁺, Ca²⁺, Mg²⁺, Fe³⁺, Al³⁺, SO₄²⁻, Cl⁻ are removed by suitable means such as an ion exchange resin. The content of solvent in the mixture of step (a) may be 25-60 wt.-%, preferably 35-45 wt.% based on the total mass of the mixture.

The mixture provided in step (a) further comprises silica. The silica may e.g. be fumed silica, precipitated silica, or mixtures thereof. In a preferred embodiment, the mixture provided in step (a) comprises fumed silica. The fumed silica can be used in the form of a powder, granulate or suspension and is preferably used in the form of a suspension in the solvent of step (a), particularly in purified water as described above.

The mixture of step (a) is preferably in liquid form and more preferably in the form of an aqueous suspension. The mixture of step (a) may be obtained by the following steps
(i) providing a mixture comprising the at least one saccharide and a solvent, particularly water,
(ii) heating the mixture of step (i) to an elevated temperature of 25-90°C, preferably 30-60°C,
(iii) subjecting the mixture having the elevated temperature to an ion exchange resin, and
(iv) mixing the product obtained after step (iii) with silica.

Steps (i)-(iv) particularly allow for a further purification of the starting materials. In step (i) a mixture comprising at least one saccharide and a solvent is provided. The amount of saccharide to solvent in the mixture of step (i) is preferably 0.1:1-1:0.5, more preferably 0.5:1-1:1. The mixture of step (i) may be in the form of a suspension or solution and is preferably a solution. In a preferred embodiment, the solvent of step (i) corresponds to the solvent of step (a) and is particularly water, more particularly demineralized water. The saccharide is as described herein.

In step (ii) the mixture is heated, preferably under stirring, to an elevated temperature of 25-90°C, preferably 30-60°C. Heating may be performed in a reaction vessel including a stirring device and a heating jacket.

In step (iii), the mixture having the elevated temperature is subjected to an ion exchange resin. The ion exchange resin may be selected from cation exchange resins, anion exchange resins or mixed-bed resins.

While in contact with the ion exchange resin, the mixture may be subjected to further heating, particularly in order to maintain the temperature constant throughout step (iii) and preferably throughout steps (ii) and (iii). Preferably, the mixture has a temperature of 25-90°C, preferably 30-60°C in step (iii). To this end, the ion exchanger (i.e. the container carrying the ion exchange resin) may comprise a heating jacket.

Step (iii) is performed at least once and preferably 1 or 2 times. By subjecting the mixture to an ion exchange resin, impurities contained in the mixture are removed, thus avoiding unintended doping of the SiC product. A method according to the present invention comprising steps (i)-(iv) particularly allows for the provision of high-purity SiC, wherein the amount of impurities is limited to a ppm to ppb range.

In step (iv) the product obtained after step (iii) is mixed with silica. Mixing is particularly performed by stirring in a reaction vessel including a stirring device. The silica is as described herein and is preferably fumed silica.

Following step (a), the method of the present invention comprises heating the mixture provided in step (a) to a temperature T1 ranging from 200°C to 600°C. In a preferred embodiment, the heating in step (b) is performed using microwave radiation. The microwave radiation may have a frequency of 900 MHz-2.45 GHz and/or may be applied at up to 2 kW, preferably 0.6-1.2 kW, per kg of mixture provided in step (a).

Step (b) can comprise subjecting the mixture to a stream of gas, such as air or an inert gas, preferably a stream of inert gas. In a preferred embodiment, step (b) comprises subjecting the mixture to a stream of inert gas selected from argon or nitrogen. The stream of gas may be introduced in the reactor accommodating the mixture at a rate of 5-20 I/min.

The pressure in step (b) is preferably below atmospheric pressure (i.e. below 1013 mbar) and is more preferably 800-1000 mbar.

In a particularly preferred embodiment, step (b) comprises
(b1) heating the mixture provided in step (a) to a temperature T1a while subjecting it to a stream of gas, and
(b2) heating the mixture provided in step (b1) to a temperature T1b while subjecting it to a stream of gas,
wherein the temperature T1a is lower than the temperature T1b.

Temperature T1a may be 75-180°C, preferably 90-120°C, and particularly 105-115°C. Temperature T1b may be 200-600°C, preferably 250-400°C and particularly 300-350°C. In a preferred embodiment, temperature T1a is 105-115°C and temperature T1b is 300-350°C.

The stream of gas in step (b1) may be selected from a stream of air or a stream of an inert gas, preferably argon, nitrogen or mixtures thereof. In a preferred embodiment, the stream of gas in step (b1) is selected from argon and nitrogen.

The stream of gas in step (b2) may be a stream of inert gas preferably selected from argon and nitrogen. Particularly, the stream of gas in step (b2) is free of oxygen.

The introduction rate of the gas stream into the reactor in step (b1) and/or step (b2) may be 5-20 I/min.

The duration of step (b1) is e.g. 5-60 min, preferably 20-45 min. The duration of step (b2) is e.g. 10-120 min, preferably 30-90 min. In a preferred embodiment, the total duration of step (b) is 15-180 min, preferably 50-135 min.

In a preferred embodiment, the present method comprises
(a) providing a mixture comprising at least one saccharide, silica and a solvent in a reactor,
(b) heating the mixture provided in step (a) to a temperature T1 ranging from 200°C to 600°C, and
(c) heating the mixture obtained in step (b) in an inert gas atmosphere to a temperature T2 ranging from 1600-2000°C to obtain SiC,
wherein the mixture of step (a) is obtained by
(i) providing a mixture comprising the at least one saccharide and the solvent, particularly water,
(ii) heating the mixture of step (i) to an elevated temperature of 25-90°C, preferably 30-60°C,
(iii) subjecting the mixture having the elevated temperature to an ion exchange resin, and
(iv) mixing the product obtained after step (iii) with silica, preferably fumed silica, and wherein step (b) comprises
   (b1) heating the mixture provided in step (a) to a temperature T1a while subjecting it to a stream of gas, preferably selected from air, argon and nitrogen, and
   (b2) heating the mixture provided in step (b1) to a temperature T1b while subjecting it to a stream of gas, preferably selected from argon and nitrogen,
   wherein the temperature T1a is lower than the temperature T1b, preferably wherein T1a is 90-120°C and/or T1b is 200-600°C.

By subjecting the mixture to elevated temperatures of 200-600°C and optionally to a stream of gas in step (b), solvent present in the mixture may be removed and organic compounds in the mixture may be pyrolyzed to carbon. In a preferred embodiment, (substantially) all of the solvent present in the mixture is removed and (substantially) all of the organic compounds are pyrolyzed. "Substantially all of the solvent" means, that the mixture obtained in step (b) comprises less than 0.5 wt. %, such as 0.001-0.5 wt. %, preferably less than 0.01 wt. % solvent with reference to the total mass of the mixture. "Substantially all of the organic compounds" means, that the mixture obtained in step (b) contains less than 1 wt. %, such as 0.001-0.5 wt. %, preferably less than 0.01 wt. % organic compounds with reference to the total mass of the mixture. The organic compounds are reduced to carbon and by-products of the pyrolysis such as H₂O, CO and/or CO₂ may be removed by the gas stream provided in step (b).

The percentage mass reduction in step (b1) calculated from the mass loss of the mixture during step (b1) / the mass of the mixture provided in step (a) may be 25-60 %, preferably 35-45 %. In a preferred embodiment, step (b1) is performed until a mass reduction corresponding to 90 % or more, preferably 99 % or more of the solvent content in the mixture after step (a) is reached. By subjecting the mixture to elevated temperatures and optionally to a stream of (inert) gas in step (b1), solvent present in the mixture may be at least partially removed. In a preferred embodiment, more than 90% of the solvent present in the mixture is removed in step (b1). The remaining solvent content is preferably <10 wt. % solvent with reference to the total mass of the mixture. In a preferred embodiment, step (b1) is performed until the mixture is present in solid form.

The percentage mass reduction in step (b2) calculated from the mass loss of the mixture during step (b2) / the mass of the mixture provided in step (b1) may be 30-80 %, preferably 45-55 %. By subjecting the mixture to elevated temperatures and optionally to a stream of inert gas in step (b2), optionally remaining solvent may be removed. Further, the mixture is pyrolyzed and by-products resulting from the pyrolysis of the mixture when subjected to elevated temperatures, such as H₂O, CO and/or CO₂, may be removed. The mixture obtained in step (b) comprises and preferably consists of carbon and silica. Impurities such as B, Na, Mg, Al, K, Ca, Ti, V, Cr, Fe, Co, Ni, Cu, Zn, Sn, W, and/or Pb may be present in an amount of < 6 ppm each.

In a preferred embodiment, the percentage total mass reduction in step (b) calculated from the mass loss of the mixture during step (b) / the mass of the mixture provided in step (a) is 50-80 %, preferably 65-75 %. By using microwave radiation to heat the mixture in step (b), the energy input is highly efficient. Particularly, the mass reduction per energy used in step (b) may be > 0.9 kg per kWh. This allows for a cost effective and resource-saving operation of step (b). Further, the overall duration of the drying and pyrolysis reaction is shortened in comparison to conventional radiation-based heating systems. This further increases cost efficiency and eco-friendliness of the method according to the present invention.

To obtain SiC, the mixture obtained in step (b) is heated in an inert gas atmosphere to a temperature T2 ranging from 1600-2000°C (step (c)). Heating in step (c) allows for a carbothermic reduction of the mixture obtained in step (b). Particularly, the following reaction can take place in step (c)

SiO₂ + 3C → SiC + 2 CO

To obtain high-purity SiC, the ratio of Si to C in the mixture subjected to step (c) is of particular relevance. A suitable Si to C ratio is particularly achieved by adjusting the Si to C ratio in the mixture provided in step (a) and by adjusting the temperature and duration of steps (b1) and (b2) to prevent carbon loss caused by uncontrolled decomposition. By this means, an excess of free carbon or free silicon in the SiC product is avoided. "Free" carbon or silicon means, that it is not present in the form of SiC. In a preferred embodiment, the product obtained in step (c) has a residual free carbon content of <5% and/or a residual free silicon content of <0.1%. Preferably, the product obtained in step (c) has a SiC content of at least 95%, more preferably > 99.5%.

Step (c) is performed in an inert gas atmosphere, wherein the inert gas is preferably argon. Preferably, heating is performed while a stream of inert gas, preferably a stream of argon, is applied to the mixture treated in step (c). The stream of gas may be applied at a rate of 0.25-4.0 I/min, preferably 1.0-2.0 I/min.

The temperature T2 preferably ranges from 1600-2000°C and more preferably from 1700-1800°C. The total duration of step (c) may be 8 to 24 h.

Heating in step (c) may be performed in a reactor using microwave radiation or inductive heating. In a preferred embodiment, heating in step (b) is performed using microwave radiation and heating in step (c) is performed using inductive heating.

In another embodiment, heating in step (c) is performed in a reactor using microwave radiation having a frequency of 900 MHz-2.45 GHz and/or applied at up to 3 kW, preferably 1.2-1.8 kW, per kg mixture obtained in step (b). In a preferred embodiment, heating in steps (b) and (c) is performed in a reactor using microwave radiation having a frequency of 900 MHz-2.45 GHz. By using microwave radiation, the energy input is highly efficient. This allows for a cost effective and resource-saving operation of step (c).

The percentage mass reduction in step (c) calculated from the mass loss of the material during step (c) / the mass of the mixture obtained in step (b) is preferably 50-80%, more preferably 60-70%. The percentage total mass reduction in step (c) calculated from the mass loss of the material during step (c) / the mass of the mixture obtained in step (a) is preferably 65-95%, more preferably 80-90%.

The method according to the present invention can further comprise the step of (v) grinding the product obtained in step (b1), (b2) and/or (c) to provide a ground product. In a preferred embodiment, the method of the present invention comprises at least one, and preferably one, grinding step (v).

In one embodiment, the method of the present invention comprises
(a) providing a mixture comprising at least one saccharide, silica and a solvent, preferably water, in a reactor,
(b) heating the mixture provided in step (a) to a temperature T1 ranging from 200°C to 600°C, comprising
   (b1) heating the mixture provided in step (a) to a temperature T1a while subjecting it to a stream of gas, preferably selected from air, argon and nitrogen, and (v) grinding the product obtained, and
   (b2) heating the ground mixture provided in step (b1) to a temperature T1b while subjecting it to a stream of gas, preferably selected from argon and nitrogen, wherein the temperature T1a is lower than the temperature T1b, preferably wherein T1a is 90-120°C and/or T1b is 200-600°C, and
(c) heating the mixture obtained in step (b) in an inert gas atmosphere to a temperature T2 ranging from 1600-2000°C to obtain SiC.

In another embodiment, the method of the present invention comprises
(a) providing a mixture comprising at least one saccharide, silica and a solvent, preferably water, in a reactor,
(b) heating the mixture provided in step (a) to a temperature T1 ranging from 200°C to 600°C, comprising
   (b1) heating the mixture provided in step (a) to a temperature T1a while subjecting it to a stream of gas, preferably selected from air, argon and nitrogen, and
   (b2) heating the mixture provided in step (b1) to a temperature T1b while subjecting it to a stream of gas, preferably selected from argon and nitrogen, and (v) grinding the product obtained,
   wherein the temperature T1a is lower than the temperature T1b, preferably wherein T1a is 90-120°C and/or T1b is 200-600°C, and
(c) heating the ground mixture obtained in step (b) in an inert gas atmosphere to a temperature T2 ranging from 1600-2000°C to obtain SiC.

In still another embodiment, the method of the present invention comprises
(a) providing a mixture comprising at least one saccharide, silica and a solvent, preferably water, in a reactor,
(b) heating the mixture provided in step (a) to a temperature T1 ranging from 200°C to 600°C, comprising
   (b1) heating the mixture provided in step (a) to a temperature T1a while subjecting it to a stream of gas, preferably selected from air, argon and nitrogen, and
   (b2) heating the mixture provided in step (b1) to a temperature T1b while subjecting it to a stream of gas, preferably selected from argon and nitrogen,
   wherein the temperature T1a is lower than the temperature T1b, preferably wherein T1a is 90-120°C and/or T1b is 200-600°C,
(c) heating the mixture obtained in step (b) in an inert gas atmosphere to a temperature T2 ranging from 1600-2000°C to obtain SiC, and (v) grinding the product obtained.

Grinding at least one of the products obtained in step (b1), (b2) and (c) allows for the adaption of the packaging density of the SiC produced. The packaging density of the SiC is of particular interest for a subsequent crystal growth process when it is e.g. intended to produce SiC monocrystals. In case the packaging density of the SiC material is too high or too low, the sublimation-recrystallization behavior may change unfavorably and the growth process may become unstable. For example, local heat peaks may occur in the SiC starting material if its packaging density is too high. In case the packaging density is too low, the core of the source material shrinks faster and the shrinkage leads to a larger change in growth conditions. These changes in the growth process may result in an irregular crystal growth and the formation of crystal defects. The packaging density of the ground material is preferably 30-80%, more preferably 50-80% of the theoretical density, determined by bulk density measurement in relation to theoretical density. The bulk density of the SiC is calculated from its mass divided by its volume inside a graduated cylinder.

Further, grinding influences the particle size and distribution. Preferably, the mean particle size is 50-500 µm. A large particle size and narrow size distribution improve the stability of the sublimation process of SiC during crystal growth.

The method according to the present invention can further comprise the step of (vi) forming a molded body from the product obtained in step (b1), (b2) or (c) or the ground product obtained in step (v). In one embodiment, the method according to the present invention comprises the step of (vi) forming a molded body from the optionally ground product obtained in step (b1). In another embodiment, the method according to the present invention comprises the step of (vi) forming a molded body from the optionally ground product obtained in step (b2). In a preferred embodiment, the method according to the present invention comprises the step of (vi) forming a molded body from the optionally ground product obtained in step (c). The molded body may have a porosity of 20-70%, preferably 20-40%. Measurement methods to determine the porosity are known to a person skilled in the art. Particularly, the porosity can be determined from the bulk density in relation to theoretical density, measured as described herein or (especially for irregular geometric shapes) from mercury porosimetry or a hydrostatic balance measurements.

The density of the molded body is of particular interest for a subsequent crystal growth process when it is e.g. intended to produce SiC monocrystals. In case the density of the molded body is too high or too low, the crystal growth may be negatively affected. In case the density of the molded SiC body is too high or too low, the sublimation-recrystallization behavior may change unfavorably and the growth process may become unstable.

In a preferred embodiment, Step (vi) is performed with the optionally ground product obtained in step (c) and may be performed at a temperature of 1800-2200°C preferably by press-forming and sintering in a furnace, such as a Vacuum-sintering furnace, Hot-pressing furnace or a Field Assisted Sintering Technique (FAST) furnace. The density of the molded body may particularly be controlled by the pressure applied to form the molded body. In a particularly preferred embodiment, the forming and sintering in step (vi) uses Field Assisted Sintering Technique (FAST) and may be performed at a temperature of 1800-2050°C at a pressure of 5-10 MPa.

The method according to the present invention can further comprise the step of (d) heating the product obtained in step (c), preferably present in the form of a molded body obtained by step (vi), to a temperature ranging from 2000-2400°C to form a SiC monocrystal.

In a preferred embodiment, step (d) is performed by physical vapor transport (PVT). Particularly, step (d) is performed in vacuum (i.e. below 1013 mbar) with continuous gas flow such as an argon gas containing flow. The vacuum may be kept at pressures between 0 and 100 mbar, preferably at 10-30 mbar.

The gas flow in step (d) may be an inert gas flow, e.g. consisting of argon gas, preferably applied at a rate of 0.2-4.0 I/min, more preferably 0.5-1.0l/min.

Heating to a temperature ranging from 2000-2400°C in step (d) can be performed in a reactor using inductive heating. In a preferred embodiment, steps (c) and (d) are both performed in a reactor using inductive heating. The total duration of step (d) may be 100-200 h.

By heating the product obtained in step (d) to a temperature of 2000-2400°C under vacuum, SiC sublimates. To obtain a stressless monocrystal with a minimum number of defects, sublimated SiC is preferably contacted with a surface having a temperature below the sublimation temperature and providing a SiC crystal nucleus. For example, the product obtained in step (c) may be heated in a reactor providing a controlled temperature gradient, such that sublimation of SiC at a temperature between 2000 and 2400°C and recrystallization at the SiC nucleus take place in distinct parts of the reactor, such as sublimation from a bottom part of a crucible carrying the SiC material obtained in step (c) to a top part of the crucible preferably carrying a SiC crystal nucleus. At the end of such process, the SiC monocrystal may be collected and the crucible optionally containing remaining SiC material being enriched in carbon may be reused in a further SiC monocrystal growth process.

In a preferred embodiment, the method of the present invention comprises
(a) providing a mixture comprising at least one saccharide, silica and a solvent in a reactor,
(b) heating the mixture provided in step (a) to a temperature T1 ranging from 200°C to 600°C,
(c) heating the mixture obtained in step (b) in an inert gas atmosphere to a temperature T2 ranging from 1600-2000°C to obtain SiC, and
(d) heating the product obtained in step (c), preferably present in the form of a molded body obtained by step (vi), to a temperature ranging from 2000-2400°C to form a SiC monocrystal,
wherein the mixture of step (a) is obtained by
(i) providing a mixture comprising the at least one saccharide and a solvent, particularly water,
(ii) heating the mixture of step (i) to an elevated temperature of 25-90°C, preferably 30-60°C,
(iii) subjecting the mixture having the elevated temperature to an ion exchange resin, and
(iv) mixing the product obtained after step (iii) with silica, preferably fumed silica, and wherein step (b) comprises
   (b1) heating the mixture provided in step (a) to a temperature T1a while subjecting it to a stream of gas, preferably selected from argon and nitrogen, and
   (b2) heating the mixture provided in step (b1) to a temperature T1b while subjecting it to a stream of gas, preferably selected from argon and nitrogen,
   wherein the temperature T1a is lower than the temperature T1b, preferably wherein T1a is 90-120°C and/or T1b is 200-600°C.

The method of the present invention allows for a fast, cost-effective and environmentally friendly provision of SiC and particularly SiC monocrystals. The SiC (monocrystal) of the present invention has high purity and a reduced number of defects. The presence/absence of defects in the crystal structure can be determined as known in the art such as using X-ray analysis. In a preferred embodiment, a SiC monocrystal according to the present invention is substantially free of crystal defects.

Thus, in another aspect, the present invention is directed to a SiC monocrystal obtainable by a method as described herein. A SiC monocrystal according to the present invention may have a diameter of at least 75 mm and preferably 75-300 mm. The SiC monocrystal is characterized by its high purity and a low number of defects. Particularly, a SiC monocrystal according to the present invention has a limited content of impurity elements such as B, Na, Mg, Al, K, Ca, Ti, V, Cr, Fe, Co, Ni, Cu, Zn, Sn, W, and/or Pb.

Particularly, the concentration of boron may be below 10 ppm, preferably between 0.04 ppm and 0.0001 ppm.

The concentration of sodium may be below 10 ppm, preferably between 0.15 ppm and 0.0001 ppm.

The concentration of magnesium may be below 10 ppm, preferably between 0.35 ppm and 0.0001 ppm.

The concentration of aluminum may be below 10 ppm, preferably between 1.8 ppm and 0.0001 ppm.

The concentration of potassium may be below 10 ppm, preferably between 0.22 ppm and 0.0001 ppm.

The concentration of calcium may be below 9 ppm, preferably between 4.4 ppm and 0.0001 ppm.

The concentration of titanium may be below 10 ppm, preferably between 0.13 ppm and 0.0001 ppm.

The concentration of vanadium may be below 10 ppm, preferably between 0.04 ppm and 0.0001 ppm.

The concentration of chromium may be below 10 ppm, preferably between 0.3 ppm and 0.0001 ppm.

The concentration of iron may be below 10 ppm, preferably between 2.0 ppm and 0.0001 ppm.

The concentration of cobalt may be below 10 ppm, preferably between 0.05 ppm and 0.0001 ppm.

The concentration of nickel may be below 10 ppm, preferably between 0.34 ppm and 0.0001 ppm.

The concentration of copper may be below 10 ppm, preferably between 0.05 ppm and 0.0001 ppm.

The concentration of zinc may be below 3 ppm, preferably between 0.01 ppm and 0.0001 ppm.

The concentration of tin may be below 10 ppm, preferably between 0.05 ppm and 0.0001 ppm.

The concentration of tungsten may be below 10 ppm, preferably between 0.01 ppm and 0.0001 ppm.

The concentration of lead may be below 10 ppm, preferably between 0.05 ppm and 0.0001 ppm.

In one embodiment, the SiC monocrystal obtainable by a method according to the present invention has a concentration of boron, sodium, magnesium, aluminum, potassium, titanium, vanadium, chromium, iron, cobalt, nickel, copper, tin, tungsten, and/or lead each below 10 ppm, and/or calcium below 9 ppm, and/or zinc below 3 ppm. Preferably, the SiC monocrystal obtainable by a method according to the present invention has a concentration of boron, sodium, magnesium, aluminum, potassium, titanium, vanadium, chromium, iron, cobalt, nickel, copper, tin, tungsten, and lead each below 10 ppm, calcium below 9 ppm, and zinc below 3 ppm. In a particularly preferred embodiment, the total concentration of impurity elements in the SiC monocrystal of the present invention is less than 1 ppm, preferably less than 0.1 ppm. Impurity elements in the sense of the present invention are all elements besides Si, C and optionally doping agents, which are intentionally brought into the monocrystal.

In a further aspect, the present invention is directed to an apparatus for heating a mixture comprising at least one saccharide, silica and a solvent, the apparatus comprising
- a sealable reactor comprising a gas inlet system with gas inlet valves and at least one gas outlet including at least one gas outlet valve, configured to receive the mixture to be heated;
- a microwave heater configured to heat the mixture to be heated to a temperature T1 of 200-600°C and optionally to a temperature T2 of 1600-2000°C;
- optionally a cold trap configured to separate and collect a liquid fraction from exhaust gas exiting the reactor; and
- optionally an exhaust gas treatment unit configured to collect and further process exhaust gas exiting the cold trap and/or the reactor.

Such apparatus is particularly suitable for a method according to the present invention and more particular for step (b) and optionally step (c) as described herein. Thus, another aspect of the present invention is the use of an apparatus for heating a mixture comprising at least one saccharide, silica and a solvent as described herein in a method for producing SiC as described herein.

An apparatus for heating a mixture comprising at least one saccharide, silica and a solvent according to the present invention (in the following named heating apparatus) comprises a sealable reactor comprising a gas inlet system with gas inlet valves and at least one gas outlet including at least one gas outlet valve, configured to receive the mixture to be heated. The reactor particularly comprises a reaction chamber, which is configured to receive the mixture to be heated, and sealing means configured to seal the reactor. In a sealed state of the sealing means, gas can only enter or exit the reactor by gas inlet and gas outlet valves, respectively, when in an operating mode. In a non-operating mode of the gas inlet and gas outlet valves, the reactor chamber is completely sealed, i.e. no gas exchange may take place between the reactor chamber and the surrounding environment in a sealed state of the sealing means.

The reactor may further comprise a heating system such as a heating jacket at least partially surrounding the reactor chamber. By this means, unintended condensation of gaseous compounds, such as solvent evaporated from the mixture to be heated, at colder walls of the reactor chamber can be avoided.

The gas inlet system comprises at least one gas inlet including at least one gas inlet valve. In a preferred embodiment, the gas inlet system comprises at least two gas inlets each including at least one gas inlet valve. In a preferred embodiment, at least one gas inlet of the gas inlet system is an inert gas inlet. The gas outlet including at least one gas outlet valve is configured to remove exhaust gas from the reactor. Exhaust gas may include gaseous by-products, evaporated solvent or inert gas.

In a preferred embodiment, the reactor further comprises an in-built weighing system configured to measure a mass loss of the mixture during heating. Particularly, the in-built weighing systems is configured to determine the mass of the entire reaction chamber. By this means, the progress of the heating operation can be monitored.

The reactor may further comprise at least one temperature sensor, such as at least one pyrometer, configured to measure a temperature in the reactor, and at least one pressure sensor configured to measure a pressure in the reactor. Preferably, the reactor comprises one or two pyrometers configured to measure a temperature in the reactor.

The heating apparatus further comprises a microwave heater configured to heat the mixture to be heated to a temperature T1 of 75-600°C, such as 200-600°C and optionally to a temperature T2 of 1600-2000°C. The microwave heater may be configured to induce microwave radiation having a frequency of 2.45 GHz and/or 915 MHz at up to 2 kW, preferably 0.6-1.2 kW per kg mixture provided in step (a). By using a microwave heater, the energy input is highly efficient. This allows for a cost effective and resource-saving operation of the heating apparatus. Further, the overall duration of the heating process may be shortened. This further increases cost efficiency and eco-friendliness of the apparatus according to the present invention.

Further, the heating apparatus may comprise a controller configured to control the microwave heater and optionally the at least one temperature sensor and pressure sensor. Further, the controller may be configured to control the gas inlet system and the at least one gas outlet.

A heating power of the microwave heater can be controlled by
(i) manual input,
(ii) automatic mode with programmed time and power, and/or
(iii) automatic mode with defined temperature, preferably wherein the reactor temperature measured by temperature sensors, preferably pyrometers, is used as a control variable.

Manual input of the desired heating power can be done at the microwave heater or at a controller configured to control the microwave heater.

Automatic mode with programmed time means that the running time of the microwave heater can be set to a predetermined value prior to the heating of a mixture by the heating apparatus. A suitable time e.g. corresponds to the duration of step (b), step (b1), step (b2) or step (c) as defined herein. The running time can e.g. be set at the microwave heater or at a controller configured to control the microwave heater.

Automatic mode with programmed power means that the power applied by the microwave heater during the programmed time may be set to a predetermined value prior to the heating of a mixture by the heating apparatus. A suitable power may e.g. be up to 2 kW per kg mixture to be processed. The power can e.g. be set at the microwave heater or at a controller configured to control the microwave heater.

Automatic mode with defined temperature means that the temperature applied for heating the mixture in the reactor may be set to a predetermined value prior to the heating. A suitable temperature is e.g. between 75 and 180°C, 200 and 600°C and/or 1600 to 2000°C. In one embodiment, the defined temperature can be set to at least two values, which are applied successively for heating the mixture in the reactor, such as a first temperature of 75-180°C and a second temperature of 200-600°C. The temperature can e.g. be set at the microwave heater or at a controller configured to control the microwave heater and optionally temperature sensors configured to measure a temperature in the reactor. Preferably, the reactor temperature measured by temperature sensors, preferably one or two pyrometers, is used as a control variable to adjust the temperature to a predetermined value throughout the entire reactor chamber.

The heating apparatus can optionally comprise a cold trap configured to separate and collect a liquid fraction from exhaust gas exiting the reactor by a gas outlet valve. Such cold trap is particularly configured to separate and collect water from exhaust gas exiting the reactor by a gas outlet valve. Suitable cold traps are known to a person skilled in the art.

The heating apparatus can optionally comprise an exhaust gas treatment unit configured to collect and further process exhaust gas exiting the cold trap and/or the reactor by a gas outlet valve. Particularly, carbon dioxide included in the exhaust gas can be collected.

The heating apparatus according to the present invention allows for a fast and cost-effective heating of a mixture introduced therein. Further, modular and reusable crucible systems configured to receive the mixture to be heated can be used.

In another aspect, the present invention refers to an apparatus for providing a mixture comprising at least one saccharide, silica and a solvent (in the following mixing apparatus), comprising
- a first reaction vessel including a stirring device and a heating jacket configured to stir and heat a mixture comprising at least one saccharide and a solvent,
- an ion exchanger comprising an ion exchange resin and a heating jacket configured to subject a mixture heated in the first reaction vessel to the ion exchange resin,
- a collection vessel configured to receive a mixture subjected to the ion exchanger for intermediate storage and
- a second reaction vessel including a stirring device configured to receive a mixture subjected to the ion exchanger and stored in the collection vessel for mixing it with silica, wherein the first reaction vessel is configured to be in fluid contact with a first end of the ion exchanger, the collection vessel is configured to be in fluid contact with the second end of the ion exchanger and the second reaction vessel is configured to be in fluid contact with the collection vessel.

Such apparatus is particularly suitable for a method according to the present invention, and particularly for steps (i)-(iv) as described herein. Thus, another aspect of the present invention is the use of an apparatus for providing a mixture comprising at least one saccharide, silica and a solvent as described herein in a method for producing SiC as described herein.

The mixing apparatus comprises a first reaction vessel including a stirring device and a heating jacket configured to stir and heat a mixture comprising at least one saccharide and a solvent. The first reaction vessel is preferably configured to provide a homogeneous mixture and particularly a solution of the at least one saccharide and solvent. The heating jacket is preferably configured to heat a mixture comprising at least one saccharide and a solvent to a temperature of 25-90°C, preferably 30-60°C. The first reaction vessel may be sealable, particularly comprising a sealable saccharide and solvent inlet and a sealable mixture outlet.

Further, the first reaction vessel is configured to be in fluid contact with a first end of the ion exchanger. For example, the mixture outlet of the first reaction vessel and the first end of the ion exchanger may be connected by a tube including at least one valve. The apparatus may further comprise at least one pump configured to transfer a mixture present in the first reaction vessel to the first end of the ion exchanger.

The mixing apparatus further comprises an ion exchanger comprising an ion exchange resin and a heating jacket configured to subject a mixture heated in the first reaction vessel to the ion exchange resin. The ion exchange resin of the ion exchanger is as described herein. The heating jacket is particularly configured to maintain the temperature of the mixture constant while being in contact with the ion exchange resin.

The ion exchanger may comprise one ion exchange column or a system of at least two ion exchange columns. The at least two ion exchange columns of the system may comprise the same ion exchange resin or different ion exchange resins. In one embodiment, at least one ion exchange column of the system is in an operating mode, and at least one ion exchange column of the system is in a resin regeneration or maintenance mode.

The mixing apparatus further comprises a collection vessel, which is configured to be in fluid contact with the second end of the ion exchanger, which is different from the first end of the ion exchanger. That is, the collection vessel is configured to receive a mixture subjected to the ion exchanger. For example, the mixture inlet of the collection vessel and the second end of the ion exchanger may be connected by a tube including at least one valve. The collection vessel is additionally in fluid contact with the second reaction vessel. In one embodiment, the collection vessel is additionally configured to be in fluid contact with the first end of the ion exchanger. In one embodiment, the collection vessel is configured to be in fluid contact with the first and the second end of the ion exchanger e.g. by tubes each including at least one valve. The apparatus may further comprise at least one pump configured to transfer a mixture from the collection vessel to the first end of the ion exchanger. This allows for repeatedly subjecting the mixture to an ion exchange resin. In a preferred embodiment, the collection vessel comprises a heating jacket configured to maintain the temperature of a mixture present in the vessel interior at a predetermined temperature.

In a preferred embodiment, the collection vessel is configured to be in fluid contact with the second end of the ion exchanger, the second reaction vessel (preferably by the mixture inlet) and optionally the first end of the ion exchanger e.g. by tubes each including at least one valve. The apparatus may further comprise at least one pump configured to transfer a mixture from the collection vessel to the second reaction vessel or to the first end of the ion exchanger.

The mixing apparatus further comprises a second reaction vessel including a stirring device configured to receive a mixture subjected to the ion exchanger and intermediately stored in the collection vessel for mixing it with silica. The second reaction vessel may be sealable, particularly comprising a sealable mixture inlet, a sealable silica inlet and a sealable mixture outlet. The apparatus may further comprise at least one pump configured to transfer a mixture from the collection vessel to the second reaction vessel. The mixture outlet of the second reaction vessel may contain a valve. In one embodiment, the mixture outlet of the second reaction vessel may further comprise a pump configured to transfer a mixture from the second reaction vessel to external containers.

Further, the mixing apparatus may be sealable, i.e. no gas exchange is possible between the inside of the apparatus and the surrounding atmosphere. By this means, the purity of the mixture obtainable is further increased.

The present invention is further defined by, but not limited to, the following example.

Demineralized water and sucrose were mixed in a mass ratio of 1:1 in a first reaction vessel and heated to an elevated temperature of 70 °C to provide a heated sucrose solution. The heated solution was subjected to an ion exchange resin having a mixed-bed resin and collected in a second reaction vessel. The solution was mixed with fumed silica resulting in a suspension having a mass ratio of silicon to carbon of 1:1.5.

The suspension was transferred to a reactor and heated using microwave radiation (frequency 2.45 GHz, power 8 kW) to a temperature of 110°C (T1a) at a pressure of 850 mbar while being subjected to a stream of argon for 30 min to obtain a dried mixture. Next, the dried mixture was heated using microwave radiation (frequency 2.45 GHz, power 8 kW) to a temperature of 350°C (T1b) at a pressure of 850 mbar while being subjected to a stream of argon for 30 min to obtain a pyrolyzed mixture. The percentage mass reduction calculated from the mass of the pyrolyzed mixture / the mass of the mixture provided to the reactor was 60%.

The pyrolyzed mixture was transferred to a sealable crucible and heated using inductive heating to a temperature of 1800°C (T2) at a pressure of 900 mbar while being subjected to a stream of argon for 10 h to obtain a SiC containing product. The percentage mass reduction calculated from the mass of the SiC containing product / the mass of the mixture provided in the crucible was 62.3%. The product had a SiC content of >99.999% as determined by GD-MS (glow-discharge mass spectrometry).

The SiC product were transferred to a graphite crucible. The crucible was sealed with a graphite lid carrying a SiC crystal nucleus and subjected to a temperature gradient, wherein the bottom part of the crucible carrying the SiC product was heated to a temperature of 2350°C and the lid was heated to a temperature of 2130°C. During the heating process, the pressure in the reactor was decreased from 800 to 10 mbar. Heating was performed for 140 h.

A high-purity SiC monocrystal having a diameter of 100 mm was obtained.

The present invention is further defined by, but not limited to, the subject matter of the following items.
1. A method for producing SiC, comprising the following steps:
   (a) providing a mixture comprising at least one saccharide, silica and a solvent in a reactor,
   (b) heating the mixture provided in step (a) to a temperature T1 ranging from 200°C to 600°C, and
   (c) heating the mixture obtained in step (b) in an inert gas atmosphere to a temperature T2 ranging from 1600-2000°C to obtain SiC.
2. The method of item 1, wherein the saccharide is selected from mono- or oligosaccharides, preferably from di- or trisaccharides, or mixtures thereof.
3. The method of any of the preceding items, wherein the saccharide is selected from glucose, fructose, galactose, maltose, isomaltose, sucrose, lactose, raffinose, maltotriose or mixtures thereof.
4. The method of any of the preceding items, wherein the saccharide has a molecular mass of 50-600 g/mol, preferably 200-400 g/mol, more preferably 300-400 g/mol.
5. The method of any of the preceding items, wherein the mixture of step (a) has a ratio of carbon to silicon of 3:1-7:1, preferably 4:1-6:1, particularly 5:1.
6. The method of any of the preceding items, wherein the content of saccharide in the mixture of step (a) is 30-45 wt.-%, preferably 35-42 wt.% based on the total mass of the mixture.
7. The method of any of the preceding items, wherein the content of silica in the mixture of step (a) is 9-30 wt.-%, preferably 14-18 wt.% based on the total mass of the mixture.
8. The method of any of the preceding items, wherein the solvent is water, an alcohol or a mixture thereof, particularly demineralized water.
9. The method of any of the preceding items, wherein the silica is fumed silica, precipitated silica or mixtures thereof.
10. The method of any of the preceding items, wherein the silica is fumed silica in the form of a powder, granulate or suspension.
11. The method of any of the preceding items, wherein the mixture of step (a) is in liquid form and preferably in the form of an aqueous suspension.
12. The method of any of the preceding items, wherein the mixture of step (a) is obtained by the following steps
   (i) providing a mixture comprising the at least one saccharide and a solvent, particularly water,
   (ii) heating the mixture of step (i) to an elevated temperature of 25-90°C, preferably 30-60°C,
   (iii) subjecting the mixture having the elevated temperature to an ion exchange resin, and
   (iv) mixing the product obtained after step (iii) with silica.
13. The method of any of item 12, wherein the amount of saccharide to solvent in the mixture of step (i) is 0.1:1-1:0.5, preferably 0.5:1-1:1.
14. The method of any of the items 12-13, wherein the solvent of step (i) is water, particularly demineralized water.
15. The method of any of the items 12-14, wherein the solvent of step (i) corresponds to the solvent of step (a).
16. The method of any of the items 12-15, wherein the mixture of step (i) is in the form of a solution.
17. The method of any of the items 12-16, wherein the ion exchange resin is selected from cation exchange resins, anion exchange resins or mixed-bed resins.
18. The method of any of the items 12-17, wherein step (iii) is performed at least once, preferably 1-2 times.
19. The method of any of the preceding items, wherein the heating in step (b) is performed using microwave radiation.
20. The method of item 19, wherein the microwave radiation has a frequency of 900 MHz-2.45 GHz.
21. The method of any of the items 19-20, wherein the microwave radiation is applied at up to 2 kW, preferably 0.6-1.2 kW per kg of mixture provided in step (a).
22. The method of any of the preceding items, wherein step (b) comprises subjecting the mixture to a stream of gas, preferably a stream of inert gas, preferably selected from argon or nitrogen.
23. The method of any of the preceding items, wherein step (b) comprises
   (b1) heating the mixture provided in step (a) to a temperature T1a while subjecting it to a stream of gas, and
   (b2) heating the mixture provided in step (b1) to a temperature T1b while subjecting it to a stream of gas,
   wherein the temperature T1a is lower than the temperature T1b.
24. The method of item 23, wherein the stream of gas in step (b1) is selected from a stream of air or a stream of an inert gas, preferably selected from argon and nitrogen.
25. The method of any of the items 23-24, wherein the stream of gas in step (b1) is introduced into the reactor at a rate of 5-20 I/min.
26. The method of any of the items 23-25, wherein the stream of gas in step (b2) is an inert gas, preferably selected from argon and nitrogen.
27. The method of any of the items 23-26, wherein the stream of gas in step (b2) is free of oxygen.
28. The method of any of the items 23-27, wherein the stream of gas in step (b2) is introduced into the reactor at a rate of 5-20 I/min.
29. The method of any of the items 23-28, wherein the temperature T1a is 75-180°C, preferably 90-120°C, more preferably 105-115°C.
30. The method of any of the items 23-29, wherein the temperature T1b is 200-600°C, preferably 250-400°C, more preferably 300-350°C.
31. The method of any of the items 23-30, wherein step (b1) has a duration of 5-60 min, preferably 20-45 min.
32. The method of any of the items 23-31, wherein step (b2) has a duration of 10-120 min, preferably 30-90 min.
33. The method of any of the preceding items, wherein step (b) has a total duration of 15-180 min, preferably 50-135 min.
34. The method of any of the items 23-33, wherein the percentage mass reduction in step (b1) calculated from the mass of the mixture obtained in step (b1) / the mass of the mixture provided in step (a) is 25-60 %, preferably 35-45 %.
35. The method of any of the items 23-34, wherein the percentage mass reduction in step (b2) calculated from the mass of the mixture obtained in step (b2) / the mass of the mixture provided in step (b1) is 30-80 %, preferably 45-55 %.
36. The method of any of the preceding items, wherein the percentage total weight reduction in step (b) calculated from the weight of the mixture obtained in step (b) / the weight of the mixture provided in step (a) is 60-80 %, preferably 65-75 %.
37. The method of any of the preceding items, wherein the weight reduction per rendered power in step (b) is 0.1-2 kg per 0.5-1.5 kW.
38. The method of any of the preceding items, wherein the pressure in step (b) is below atmospheric pressure (1013 mbar) and is preferably 800-1000 mbar.
39. The method of any of the preceding items, wherein the inert gas in step (c) is argon.
40. The method of any of the preceding items, wherein T2 ranges from 1600-2000°C, preferably 1700-1800°C.
41. The method of any of the preceding items, wherein step (c) has a total duration of 8 to 24 h.
42. The method of any of the preceding items, wherein the heating in step (c) is performed in a reactor using microwave radiation or inductive heating.
43. The method of any of the preceding items, wherein the heating in step (c) is performed in a reactor using microwave radiation having a frequency of 900 MHz-2.45 GHz.
44. The method of any of the preceding items, wherein the heating in step (c) is performed in a reactor using microwave radiation applied at up to 2 kW, preferably 0.6-1.2 kW per kg mixture obtained in step (b).
45. The method of any of the preceding items, wherein the product obtained in step (c) has a SiC content of at least 95%, preferably > 99.5%.
46. The method of any of the preceding items, wherein the product obtained in step (c) has a residual free carbon content of <5%.
47. The method of any of the preceding items, wherein the product obtained in step (c) has a residual Si-content of <0.1%.
48. The method of any of the preceding items, wherein the percentage mass reduction in step (c) calculated from the mass of the product obtained in step (c) / the mass of the mixture obtained in step (b) is 50-80%, preferably 60-70%.
49. The method of any of the preceding items, wherein the percentage total mass reduction in step (c) calculated from the mass of the product obtained in step (c) / the mass of the mixture obtained in step (a) is 65-95%, preferably 80-90%.
50. The method of any of the preceding items, wherein the method further comprises the step of (v) grinding the product obtained in step (b1), (b2) and/or (c).
51. The method of any of the preceding items, wherein the method further comprises the step of (vi) forming a molded body from the product obtained in step (b1), (b2) or (c) or the ground product obtained in step (v).
52. The method of any of the preceding items, wherein the method comprises the step of (vi) forming a molded body from the optionally ground product obtained in step (c), wherein the molded body has a porosity of 30-80%, preferably 50-80% determined by bulk density measurement in relation to theoretical density.
53. The method of any of items 51-52, wherein step (vi) is performed at a temperature of 1800-2800°C preferably by using a sintering furnace.
54. The method of any of items 51-53, wherein the forming in step (vi) includes press-forming.
55. The method of any of the preceding items, wherein the method further comprises the step of (d) heating the product obtained in step (c), preferably present in the form of a molded body obtained by step (vi), to a temperature ranging from 2000-2400°C to form a SiC monocrystal.
56. The method of item 55, wherein step (d) is performed by physical vapor transport (PVT).
57. The method of any of the items 55-56, wherein step (d) is performed in vacuum (i.e. below 1013 mbar) with continuous gas flow such as argon gas flow.
58. The method of any of the items 55-57, wherein the vacuum in step (d) is kept at pressures between 0 and 100 mbar, preferably at 10-30 mbar.
59. The method of any of the items 55-58, wherein the gas flow in step (d) is an inert gas flow or includes a doping agent, preferably nitrogen.
60. The method of any of the items 55-59, wherein the heating in step (d) is performed in a reactor using inductive heating.
61. The method of any of the items 55-60, wherein step (d) has a total duration of 100-200 h.
62. A SiC monocrystal obtainable by a method according to any of items 1-61.
63. The SiC monocrystal according to item 62, having a concentration of
   a) boron below 10 ppm, preferably between 0.04 ppm and 0.0001 ppm;
   b) sodium below 10 ppm, preferably between 0.15 ppm and 0.0001 ppm;
   c) magnesium below 10 ppm, preferably between 0.35 ppm and 0.0001 ppm;
   d) aluminum below 10 ppm, preferably between 1.8 ppm and 0.0001 ppm;
   e) potassium below 10 ppm, preferably between 0.22 ppm and 0.0001 ppm;
   f) calcium below 9 ppm, preferably between 4.4 ppm and 0.0001 ppm;
   g) titanium below 10 ppm, preferably between 0.13 ppm and 0.0001 ppm;
   h) vanadium below 10 ppm, preferably between 0.04 ppm and 0.0001 ppm;
   i) chromium below 10 ppm, preferably between 0.3 ppm and 0.0001 ppm;
   j) iron below 10 ppm, preferably between 2.0 ppm and 0.0001 ppm;
   k) cobalt below 10 ppm, preferably between 0.05 ppm and 0.0001 ppm;
   l) nickel below 10 ppm, preferably between 0.34 ppm and 0.0001 ppm;
   m) copper below 10 ppm, preferably between 0.05 ppm and 0.0001 ppm;
   n) zinc below 3 ppm, preferably between 0.01 ppm and 0.0001 ppm;
   o) tin below 10 ppm, preferably between 0.05 ppm and 0.0001 ppm;
   p) tungsten below 10 ppm, preferably between 0.01 ppm and 0.0001 ppm; and/or
   q) lead below 10 ppm, preferably between 0.05 ppm and 0.0001 ppm.
64. An apparatus for heating a mixture comprising at least one saccharide, silica and a solvent, the apparatus comprising
   - a sealable reactor comprising a gas inlet system with gas inlet valves and at least one gas outlet including at least one gas outlet valve, configured to receive the mixture to be heated;
   - a microwave heater configured to heat the mixture to be heated to a temperature T1 of 200-600°C and optionally to a temperature T2 of 1600-2000°C;
   - optionally a cold trap configured to separate and collect a liquid fraction from exhaust gas exiting the reactor by a gas outlet valve; and
   - optionally an exhaust gas treatment unit configured to collect and further process exhaust gas exiting the cold trap and/or the reactor by a gas outlet valve.
65. The apparatus of item 64, wherein at least one gas inlet is an inert gas inlet.
66. The apparatus of any of items 64-65, wherein the microwave heater is configured to induce microwave radiation having a frequency of 2.45 GHz and/or 915 MHz at up to 2 kW, preferably 0.6-1.2 kW per kg mixture provided in step (a).
67. The apparatus of any of items 64-66, wherein the reactor comprises an in-built weighing system configured to measure the mass loss of the mixture during heating.
68. The apparatus of any of items 64-67, wherein the reactor comprises at least one temperature sensor configured to measure a temperature in the reactor, and at least one pressure sensor configured to measure a pressure in the reactor.
69. The apparatus of any of items 64-68, wherein the reactor comprises one or two pyrometers configured to measure a temperature in the reactor.
70. The apparatus of any of items 64-69, wherein a heating power of the microwave heater can be controlled by
   (i) manual input,
   (ii) automatic mode with programmed time and power, and/or
   (iii) automatic mode with defined temperature, preferably wherein the reactor temperature measured by temperature sensors, preferably the pyrometers according to item 69, is used as a control variable.
71. Use of an apparatus according to any of items 64-70 in a method according to any of items 1-61.
72. An apparatus for providing a mixture comprising at least one saccharide, silica and a solvent, comprising
   - a first reaction vessel including a stirring device and a heating jacket configured to stir and heat a mixture comprising at least one saccharide and a solvent,
   - an ion exchanger comprising an ion exchange resin and a heating jacket configured to subject a mixture heated in the first reaction vessel to the ion exchange resin, and
   - a second reaction vessel including a stirring device configured to receive a mixture subjected to the ion exchanger for mixing it with silica,
   wherein the first reaction vessel is configured to be in fluid contact with a first end of the ion exchanger and the second reaction vessel is configured to be in fluid contact with a second end of the ion exchanger.
73. The apparatus of item 72, further comprising a collection vessel configured to be in fluid contact with the second end of the ion exchanger to receive a mixture subjected to the ion exchanger for intermediate storage, and wherein the second reaction vessel is configured to be in fluid contact with the collection vessel.
74. The apparatus of any of items 72-73, wherein the ion exchanger comprises of at least one ion exchange column or a system of two ion exchange column.
75. Use of an apparatus according to any of items 72-74 in a method according to any of items 1-61.

## Claims

1. A method for producing SiC, comprising the following steps:
(a) providing a mixture comprising at least one saccharide, silica and a solvent in a reactor,
(b) heating the mixture provided in step (a) to a temperature T1 ranging from 200°C to 600°C, and
(c) heating the mixture obtained in step (b) in an inert gas atmosphere to a temperature T2 ranging from 1600-2000°C to obtain SiC.

2. The method of claim 1, wherein the saccharide is selected from glucose, fructose, galactose, maltose, isomaltose, sucrose, lactose, raffinose, maltotriose or mixtures thereof, and/or wherein the solvent is water, and/or wherein the silica is fumed silica.

3. The method of any of the preceding claims, wherein the mixture of step (a) has a ratio of carbon to silicon of 3:1-7:1, preferably 4:1-6:1, particularly 5:1.

4. The method of any of the preceding claims, wherein the mixture of step (a) is obtained by the following steps
(i) providing a mixture comprising the at least one saccharide and a solvent, particularly water,
(ii) heating the mixture of step (i) to an elevated temperature of 25-90°C, preferably 30-60°C,
(iii) subjecting the mixture having the elevated temperature to an ion exchange resin, preferably a cation exchange resin, anion exchange resin or mixed-bed resin, and
(iv) mixing the product obtained after step (iii) with silica, preferably fumed silica.

5. The method of any of the preceding claims, wherein the heating in step (b) is performed using microwave radiation, preferably having a frequency of 900 MHz-2.45 GHz and/or
wherein the heating in step (c) is performed using microwave radiation, preferably having a frequency of 900 MHz-2.45 GHz, or inductive heating.

6. The method of any of the preceding claims, wherein step (b) comprises
(b1) heating the mixture provided in step (a) to a temperature T1a while subjecting it to a stream of gas, preferably selected from air, argon and nitrogen, and
(b2) heating the mixture provided in step (b1) to a temperature T1b while subjecting it to a stream of gas, preferably selected from argon and nitrogen,
wherein the temperature T1a is lower than the temperature T1b, preferably wherein T1a is 75-180°C and/or T1b is 200-600°C.

7. The method of any of the preceding claims, wherein the method further comprises at least one of
(v) grinding the product obtained in step (b1), (b2) and/or (c); and
(vi) forming a molded body from the product obtained in step (b1), (b2) or (c) or the ground product obtained in step (v), preferably wherein step (vi) is performed at a temperature of 1800-2200°C.

8. The method of any of the preceding claims, wherein the method further comprises (d) heating the product obtained in step (c), preferably present in the form of a molded body obtained by step (vi) according to claim 7, to a temperature ranging from 2000-2400°C to form a SiC monocrystal.

9. A SiC monocrystal obtainable by a method according to any of claims 1-8, preferably having a concentration of boron, sodium, magnesium, aluminum, potassium, titanium, vanadium, chromium, iron, cobalt, nickel, copper, tin, tungsten and/or lead each below 10 ppm, and/or calcium below 9 ppm, and/or zinc below 3 ppm.

10. An apparatus for heating a mixture comprising at least one saccharide, silica and a solvent, the apparatus comprising
- a sealable reactor comprising a gas inlet system with gas inlet valves and at least one gas outlet including at least one gas outlet valve, configured to receive the mixture to be heated;
- a microwave heater configured to heat the mixture to be heated to a temperature T1 of 200-600°C and optionally to a temperature T2 of 1600-2000°C;
- optionally a cold trap configured to separate and collect a liquid fraction from exhaust gas exiting the reactor by a gas outlet valve; and
- optionally an exhaust gas treatment unit configured to collect and further process exhaust gas exiting the cold trap and/or the reactor by a gas outlet valve.

11. The apparatus of claim 10, wherein the reactor comprises an in-built weighing system configured to measure the mass loss of the mixture during heating and/or wherein the reactor comprises at least one temperature sensor configured to measure a temperature in the reactor, and at least one pressure sensor configured to measure a pressure in the reactor.

12. Use of an apparatus according to any of claims 10-11 in a method according to any of claims 1-8.

13. An apparatus for providing a mixture comprising at least one saccharide, silica and a solvent, comprising
- a first reaction vessel including a stirring device and a heating jacket configured to stir and heat a mixture comprising at least one saccharide and a solvent,
- an ion exchanger comprising an ion exchange resin and a heating jacket configured to subject a mixture heated in the first reaction vessel to the ion exchange resin, and
- a collection vessel configured to receive a mixture subjected to the ion exchanger for intermediate storage, and
- a second reaction vessel including a stirring device configured to receive a mixture stored in the collection vessel for mixing it with silica,
wherein the first reaction vessel is configured to be in fluid contact with a first end of the ion exchanger, the collection vessel is configured to be in fluid contact with a second end of the ion exchanger and the second reaction vessel is configured to be in fluid contact with the collection vessel.

14. The apparatus of claim 13, wherein the ion exchanger comprises one ion exchange column or a system of at least two ion exchange columns.

15. Use of an apparatus according to any of claims 13-14 in a method according to any of claims 1-8.
